# EUROPÄISCHE PATENTSCHRIFT

(11) **EP 1 187 224 B1**
(45) Veröffentlichungstag und Bekanntmachung des Hinweises auf die Patenterteilung: **22.03.2006**
(21) Anmeldenummer: 00119751.6
(22) Anmeldetag: 11.09.2000
(51) Int. Cl.: H01L 31/18, C22B 17/02, C22B 11/00

(54) **Recycling-Verfahren für CdTe/CdS-Dünnschichtsolarzellenmodule**
Recycling method for CdTe/CdS thin film solar cell modules
Méthode de recyclage pour modules de cellules solaires en couche minces en CdTe/CdS

(43) Veröffentlichungstag der Anmeldung: 13.03.2002
(73) Patentinhaber: ANTEC Solar Energy AG, 60311 Frankfurt am Main (DE)
(72) Erfinder: Campo, Manuel Dieguez, Dr., 63457 Hanau (DE); Bonnet, Dieter, dr., 61381 Friedrichsdorf (DE); Gegenwart, Rainer, Dr., 63322 Rödermark (DE); Beier, Jutta, Dr., 65719 Hofheim (DE)
(74) Vertreter: Grünberg, Thomas

(56) Entgegenhaltungen:
- EP-A- 0 893 250
- WO-A-00/47343
- DE-A- 4 337 309
- US-A- 5 453 111
- US-A- 5 897 685
- R. A. SASALA ET AL.: "Physical and chemical pathways for economic recycling of cadmium telluride thin-film photovoltaic modules" 25TH IEEE PHOTOVOLTAIC SPECIALISTS CONFERENCE, 13. - 17. Mai 1996, Seiten 865-868, XP002162282 WASHINGTON, DC, USA

## Beschreibung

Die Erfindung betrifft ein Recycling-Verfahren für CdTe/CdS-Dünnschichtsolarzellenmodule. EP-A-893250 offenbart ein Verfahren zur Trennung von Si-Solarmodulen in einer Gasatmosphäre.

CdTe-Dünnschichtsolarzellen in Form von CdTe/CdS-Dünnschichtsolarzellen sind beispielsweise in der EP 0 535 522 A2 offenbart. Die großflächigen Module derartiger Zellen liegen dem erfindungsgemäßen Verfahren zugrunde. Die Module weisen ein Fensterglassubstrat (Natron-Kalk-Glas) auf, das mit einer TCO-Schicht (vorzugsweise ITO-Schicht), einer dünnen CdS-Schicht (z.B. 100 nm dick) und einer CdTe-Schicht (z.B. zwischen 3 und 7 µm dick) beschichtet ist, auf der sich eine aufgedampfte Rückkontaktschicht aus Metall (beispielsweise Nickel) oder eine Doppelschicht aus Halbleiterschicht (beispielsweise Tellur) plus Metallschicht befindet. Das Modul ist nach einem in der US 4 243 432 aufgezeigten Prinzip so strukturiert und bearbeitet, daß er z.B. etwa 100 individuelle Zellen pro Meter seiner Länge aufweist. Er ist auf seiner der Lichteinfallseite abgewandten Rückseite mit einem Rückglas abgedeckt, das mit einem Kunststofikleber aufgeklebt ist. Dieser besteht aus einem chlorfreien Kunststoffkleber auf Kohlenwasserstoffbasis, im zugrunde gelegten Modul aus Ethylen/ Vinylacetat-Copolymeren (E/VA oder EVA). Das Rückglas ist mit Standardverfahren mittels einer EVA-Folie mit dem beschichteten und strukturierten Substratmodulglas verbindbar. Die an den Kontakten der äußeren Zellen angebrachten Zuleitungen z.B. in Form von Metallbändem sind durch eine Bohrung im Rückglas aus dem Modul herausgeführt.

In der US 5 453 111 ist ein ähnliches Modul zugrunde gelegt, das auch mit dem erfindungsgemäßen Verfahren der vorliegenden Anmeldung behandelbar ist. In diesem US Patent findet sich ein guter Überblick über die verschiedenen z.T. recht aufwendigen Recycling-Verfahren für Solarzellenmodule (naßchemisch, pyrometallurgisch, hydrometallurgisch usw.). Die Zellen werden gemäß diesem US Patent z.B. in üblichen Shredderanlagen bis auf Erbsengröße zerkleinert und dann naßchemisch bei Temperaturen zwischen Zimmertemperatur und maximal 120 °C, bevorzugt um 80 °C zunächst mit verdünnter Salpetersäure behandelt, um die vorhandenen Metalle zu oxidieren und in die Behandlungslösung zu bringen. Die EVA-Schicht delaminiert hierbei und kann von der Behandlungslösung abgeschöpft werden. Die auf dem Substratglas sitzende SnO-Schicht wird von der verdünnten Salpetersäure nicht gelöst. Die metallhaltige Behandlungslösung wird anschließend einer Elektrolyse mit Platinlektroden unterzogen, wobei das wiederzugewinnende Tellur sich an der Kathode abscheidet und das Cadmium in Lösung bleibt.

Die Erfinder der vorliegenden Erfindung hatten sich zur Aufgabe gestellt, ein alternatives neues Recycling-Verfahren zu entwickeln, das kostengünstig durchführbar ist.

Diese Aufgabe wir durch den Gegenstand des Anspruchs 1 gelöst. Vorteilhafte Weiterbildungen sind in den Unteransprüchen definiert.

Das erfindungsgemäße Recycling-Verfahren für CdTe/CdS-Dünnschichtsolarzellenmodule vermeidet eine naßchemische Trennung der Bestandteile der Module und arbeitet stattdessen erfolgreich nur in Gasatmosphären. Die Module werden zunächst mechanisch zerkleinert, wobei die Anforderungen an den Zerkleinerungsgrad und die Homogenität gering sind. Es reicht infolge der angewandten Gasbehandlung eine grobe Zerkleinerung zu Bruchstücken von einigen cm bis etwa 10 cm.

Die Modulbruchstücke werden zunächst einer sauerstoffhaltigen Atmosphäre bei einer Temperatur von mindestens 300 °C ausgesetzt, wobei das in den Bruchstücken enthaltene organische Klebemittel in Form eines chlorfreien Klebers auf Kohlenwasserstoffbasis (in der Regel Ethylen/Vinylacetat-Copolymer (EVA)) pyrolytisch verbrannt wird. Idealerweise entstehen hierbei H₂O und CO₂. Selbst wenn jedoch auch noch Reste an Kohlenwasserstoffverbindungen wie Methangas und dergleichen auftreten, ist dies nicht kritisch, da sämtliche Zersetzungsprodukte der Pyrolyse einfach abgesaugt werden und verbrannt werden können. Bevorzugt wird aus Kostengründen mit Luft als Sauerstoffträgergas gearbeitet. Das erfindungsgemäße Verfahren ist jedoch hierauf nicht beschränkt und kann auch mit anderen Trägergasen (z.B. Argon) und höheren Sauerstoff-Partialdrücken arbeiten. Bevorzugt erfolgt die Pyroloyse bei Temperaturen zwischen 400 °C und 520 °C. Hierdurch wird einerseits sichergestellt, daß die Verbrennung so schonend erfolgt, daß Cadmiumtellurid noch nicht verdampft. Andererseits ist die Verbrennung bei Temperaturen über 400 °C beschleunigt und es kann mit kurzen Behandlungszeiten von etwa fünf Minuten gearbeitet werden.

Die vom Klebemittel befreiten Modulbruchstücke werden einer chlor- und vorzugsweise auch stickstoffhaltigen Gasatmosphäre bei einer Temperatur von mehr als 400 °C ausgesetzt und das sich bei dem so hervorgerufenen Ätzvorgang bildende CdCl₂ und TeCl₄ werden durch Abkühlen zur Kondensation und Niederschlagbildung gebracht. Unter 400 °C ist ein Ätzvorgang zwar auch möglich, er ist jedoch so uneffektiv, daß der Energieverbrauch und die Behandlungszeiten unakzeptabel hoch werden. Bevorzugt wird deshalb auch mit höheren Temperaturen über 450 °C gearbeitet, wobei hier wenige Minuten Behandlungsdauer ausreichen, um die Metallschicht wegzuätzen.

Die bevorzugte Obergrenze der Temperatur von etwa 500 °C für den Ätzvorgang (als auch die vorausgehende Pyrolyse) ergibt sich daraus, daß von Modulen ausgegangen wird, die als Substratmaterial Natron-Kalk-Glas (Fensterglas) aufweisen. Bei Hochtemperaturgläsern wie Borosilicatgläsem oder dergleichen sind entsprechend höhere Temperaturen möglich. Grundsätzlich gilt, daß die Temperatur prinzipiell weitaus höher eingestellt werden könnte, jedoch durch die Wärmebeständigkeit und den Erweichungspunkt des jeweils eingesetzten Glassubstratmaterials nach oben begrenzt ist.

Die Gasatmosphäre in Schritt c) von Anspruch 1 wird bevorzugt auf Unterdruck eingestellt. Dies geschieht, um den Gasdurchsatz zu minimieren und die Ätzraten zu erhöhen. In den durchgeführten Versuchsreihen erwies sich ein Druckbereich zwischen 100 mbar und 600 mbar als geeignet. Der Druckbereich ist jedoch im Grunde in weiten Grenzen frei wählbar, insbesondere, wenn man auch einen höheren Materialverbrauch in Kauf nehmen will.

Man arbeitet in Schritt c) bevorzugt unter Zusatz von Stickstoff. Dies vereinfacht im Hinblick auf die hohe Reaktivität des Chlorgases die Verfahrensführung und macht das Verfahren deutlich umweltfreundlicher. Der Chlor-Partialdruck beträgt vorzugsweise mehr als 1% im Verhältnis zum Stickstoff-Partialdruck der Gasmischung, weil bei noch geringeren Werten die Ätzraten deutlich abnehmen. Werte über 10 % sind zwar durchaus möglich, wegen des höheren Materialverbrauchs jedoch nicht zweckmäßig, da die Ätzrate bei weiterer Steigerung kaum erhöht wird. Darüber hinaus kann der Chlorpartialdruck bei höherer Temperatur gesenkt werden.

Eine Ätzung in chlor- und stickstoffhaltiger Gasatmosphäre kann in etwa 0,5 bis 5 Minuten durchgeführt werden. Diese Werte wurden für einen Temperaturbereich von 450 °C bis 500 °C bei unterschiedlichen Druckbedingungen ermittelt. Grundsätzlich erbringt eine Steigerung der Temperatur kürzere Ätzzeiten.

Das sich beim Ätzvorgang bildende CdCl₂ und das TeCl₄ werden zweckmäßigerweise an kalten Flächen als Niederschlag gewonnen und hierzu Kühlfallen zugeführt, die sich außerhalb der eigentlichen Behandlungskammer befinden. Mögliche Ausbildungen der Kühlfallen sind denkbar einfach, zumal beide Chloride bei 150 bis 200 °C aufgrund der auftretenden Kondensation verschwindend geringe Dampfdrücke aufweisen. In einer vorteilhaften Ausgestaltung werden wassergekühlte Fallen eingesetzt.

Das sich beim Ätzvorgang bildende CdCl₂ und das TeCl₄ können auch getrennt zur Kondensation gebracht werden. Hierzu werden z.B. über einen Pumpstutzen in die Kühlfallen abgezogenen Gase zunächst auf eine Temperatur von etwa 350 °C abgekühlt, bei der lediglich das CdCl₂ einen Niederschlag bildet, und anschließend bis auf eine Temperatur von etwa 150 °C oder weniger weiter abgekühlt, bei der sich das TeCl₄ niederschlägt. Statt der 350 °C könnte man z.B. auch mit 300 °C arbeiten und statt der 150 °C z.B. auch mit 200 °C. Hierdurch würde jedoch der Abstand der beiden Temperaturwerte in eher nachteiliger Weise herabgesetzt.

Die nicht mit weggeätzte TCO-Schicht (bevorzugt ITO) kann auf dem Glas verbleiben oder mit HCL-Gas abgetragen werden, wobei sich die ensprechenden Chloride und Wasser (InCl₃, SnCl_{2,4} und H₂0) bilden (Anspruch 4).

Die erfindungsgemäße Ätzung in einer chlor- und bevorzugt auch stickstoffhaltigen Gasatmosphäre kann im übrigen auch ohne die vorhergehende Pyrolyse gemäß Schritt b) auf nicht zerteilte schon mit CdTe/CdS beschichtete Glassubstrate (die noch nicht mit dem Rückglas versehen sind) angewandt werden, um die CdTe/CdS-Schichten abzutragen. Hierdurch können Produktionsausschüsse in vorteilhafter Weise ohne naßchemische Einwirkung bewältigt werden.

Umgekehrt kann, falls die CdTe- und CdS-Schichten anders als im erfindungsgemäßen Verfahren gemäß Schritt c) entfernt werden sollen (z.B. durch ein bereits installiertes naßchemisches Verfahren oder Behandlung mit Sandstrahlen), auch der Verfahrensschritt b) der pyrolytischen Zersetzung des Kunststoff-Klebers ohne den erfindungsgemäßen Verfahrensschritt c) mit Vorteil angewandt werden.

Im folgenden wird die Erfindung anhand eines Ausführungsbeispiels erläutert.

Solarzellenmodule der eingangs erläuterten Art werden mit einem Schlagwerkzeug z.B. einer Hammermühle auf Bruchstücke von einigen cm Größe zerkleinert und in eine Behandlungskammer gebracht, die über Pumpen, Gaszufuhr- und Gasabfuhrstutzen verfügt sowie über Druckregulierventile und Druckmeßeinrichtungen. Solche Kammern werden beispielsweise für die Aktivierung von Solarzellenmodulen benötigt.

Die Metallkontakte der Module brauchen im übrigen nicht entfemt werden, um das erfindungsgemäße Verfahren erfolgreich anwenden zu können.

Im Verfahrensschritt b) wird Luft durch die Kammer gepumpt. Die Erwärmung erfolgt durch eine beliebige Heizung. Im Ausführungsbeispiel wurde ein Rohrofen mit Widerstandsheizung verwendet. Die Temperatur wird auf etwa 400 °C eingestellt. Die sich bildenden Verbrennungsgase werden abgesaugt. Nach etwa 10 bis 15 Minuten hat sich das Ethylen/Vinylacetat-Copolymer (EVA) im wesentlichen in CO₂ und H₂O zersetzt.

Anschließend wird die Kammer evakuiert und eine vorgemischte Stickstoff/Chlorgasmischung mit einem Partialdruck von 200 mbar Stickstoff und 5 mbar Chlorgas eingeleitet. Über einen hierfür vorgesehenen Pumpstutzen werden die sich beim Ätzvorgang bildenden CdCl₂ - und TeCl₄ -Gase in eine Kammer mit Kühlfallen abgesaugt. An den Kühlflächen bildet sich ein entsprechender Niederschlag.

Den Verfahrensschritt c) kann man auch in einer separaten Kammer vornehmen. Hierzu wurde eine Kammer mit Halogenstrahlem als Heizvorrichtung eingesetzt.

Alternativ werden in einer ersten Kühlfalle die CdCl₂- und das TeCl₄-Gase zunächst auf eine Temperatur von etwa 350 °C abgekühlt, bei der lediglich das CdCl₂ einen Niederschlag bildet, und:anschließend in einer zweiten nachgeschalteten Kühlfalle bis auf eine Temperatur von etwa 150 °C oder weniger weiter abgekühlt, bei der sich das TeCl₄ niederschlägt.

Die verbleibenden Glasbruchstücke mit und ohne TCO-Schicht können dann beispielsweise an Glasverarbeiter weitergegeben werden. Von besonderem Vorteil ist es allerdings, wenn die TCO-Schicht in einem sich an den Verfahrensschritt c) anschließenden weiteren Schritt d) mit HCL-Gas weggeätzt wird. Besteht die TCO-Schicht aus Zinnoxid, bildet sich nur Zinnchlorid, besteht sie aus ITO, bildet sich zusätzlich Indiumchlorid. Damit ist es möglich, das wertvolle Indium durch Aufbereitung eines entsprechenden Niederschlags zurück zu gewinnen. Auch das Zinnchlorid kann mittels einer Kühlfalle als Niederschlag aufgefangen werden. Darüber hinaus werden die nun von sämtlichen Schichten befreiten Glasbruchstücke ohne weiteres von Glasverarbeitern angenommen.

Bevorzugt wird auch hier das reaktive HCl-Gas mit Stickstoff verdünnt und man arbeitet mit einer HCL/N₂- Mischung, wobei das minimale Partialdruckverhältnis HCl zu Stickstoff vorzugsweise bei etwa 1 zu 10 liegt. Die Temperatur liegt bevorzugt wiederum über 400 °C und im Fall von Glassubstraten aus Natron-Kalk-Glas unter etwa 520 °C.

Für die erfindungsgemäße Behandlung eignen sich Schüttgutanlagen beispielsweise in Form von Trommeln, die für eine Umwirbelung des Schüttgutes während der Reaktionen sorgen.

Die Module, die mit dem erfindungsgemäßen Verfahren behandelt wurden, wiesen eine nickelhaltige Rückkontaktbeschichtung auf. Auch andere Rückkontaktmaterialien wie Molybdän oder Materialbestandteile wie Vanadium und dergleichen werden im erfindungsgemäßen Ätzschritt bereits im Schritt c) mit abgetragen. Sie können gegebenenfalls durch weitere temperaturmäßig gestaffelte Kühlfallen ebenfalls selektiv zum Niederschlag gebracht werden.

## Patentansprüche

1. Recycling-Verfahren von CdTe/CdS-Dünnschichtsolarzellenmodule, in welchem
a) die Module mechanisch zerkleinert werden,
b) die Modulbruchstücke einer sauerstoffhaltigen Atmosphäre bei einer Temperatur von mindestens 300 °C ausgesetzt werden und die sich bei der so hervorgerufenen Pyrolyse der Klebemittel auf Kohlenwasserstoffbasis, die in den Bruchstücken enthalten sind, bildenden gasförmigen Zersetzungsprodukte abgeführt werden, und
c) die von den Klebemitteln befreiten Modulbruchstücke einer chlorhaltigen Gasatmosphäre bei einer Temperatur von mehr als 400 °C ausgesetzt werden und das sich bei dem so hervorgerufenen Ätzvorgang bildende CdCl₂ und TeCl₄ durch Abkühlen zur Kondensation und Niederschlagbildung gebracht werden.

2. Verfahren nach Anspruch 1,
**dadurch gekennzeichnet**,
im Verfahrensschritt eine chlor- und stickstoffhaltige Gasatmospäre eingesetzt wird.

3. Verfahren nach Anspruch 1 oder 2,
**dadurch gekennzeichnet,**
**daß**' die Klebemittel auf Kohlenwasserstoffbasis Ethylen/Vinylacetat-Copolymere (EVA) sind.

4. Verfahren nach einem der vorhergehenden Ansprüche,
**dadurch gekennzeichnet,**
**daß** in einem zusätzlichen Verfahrensschritt d) im Anschluß an Schritt c) die auf dem Glas verbleibende TCO-Schicht mit HCL-Gas, das vorzugsweise mit Stickstoff verdünnt wird, weggeätzt wird.

5. Verfahren nach einem der vorhergehenden Ansprüche,
**dadurch gekennzeichnet,**
**daß** die Pyrolyse und gegebenenfalls der Atzvorgang in Schritt d) bei Temperaturen über 400 °C durchgeführt werden.

6. Verfahren nach einem der vorhergehenden Ansprüche,
**dadurch gekennzeichnet,**
**daß** die Gasatmosphäre im Verfahrensschritt c) und gegebenenfalls d) auf Unterdruck eingestellt wird.

7. Verfahren nach einem der Ansprüche 2 bis 6,
**dadurch gekennzeichnet,**
**daß** die chlor- und stickstoffhaltige Gasatmosphäre Chlor und Stickstoff im Partialdruckverhältnis von Chlor zu Stickstoff zwischen 0,01 und 0,1 enthält.

8. Verfahren nach einem der vorhergehenden Ansprüche,
**dadurch gekennzeichnet,**
**daß** die Pyrolyse in 1 bis 15 Minuten durchgeführt wird.

9. Verfahren nach Ansprüche einem der vorhergehenden Ansprüche,
**dadurch gekennzeichnet,**
**daß** die Ätzung in der chlor- und gegebenenfalls stickstoffhaltigen Gasatmosphäre bei Temperaturen von bevorzugt über 450 °C durchgeführt wird.

10. Verfahren nach einem der vorhergehenden Ansprüche,
**dadurch gekennzeichnet,**
**daß** das sich beim Ätzvorgang bildende CdCl₂ und das TeCl₄ an kalten Flächen als Niederschlag gewonnen werden.

11. Verfahren nach einem der vorhergehenden Ansprüche,
**dadurch gekennzeichnet,**
**daß** das sich beim Ätzvorgang bildende CdCl₂ und das TeCl₄ Kühlfallen zugeführt werden.

12. Verfahren nach einem der vorhergehenden Ansprüche,
**dadurch gekennzeichnet,**
**daß** sich das beim Ätzvorgang bildende CdCl₂ und das TeCl₄ zunächst auf eine Temperatur, bei der lediglich das CdCl₂ einen Niederschlag bildet, und anschließend bis auf eine Temperatur weiter abgekühlt werden, bei der sich das TeCl₄ niederschlägt.

13. Verfahren nach einem der vorhergehenden Ansprüche, angewandt auf noch nicht mit einem Rückglas abgedeckte, bereits mit CdTe/CdS beschichtete Glassubstrate.

## Claims

1. Recycling method for CdTe/CdS thin layer solar cell modules, in which
a) the modules are comminuted mechanically,
b) the module fragments are exposed to an oxygen-containing atmosphere at a temperature of at least 300°C and the gaseous decomposition products forming during the pyrolysis, brought about in this way, of the hydrogen-based adhesives which are contained in the fragments are led away, and
c) the module fragments freed of the adhesives are subjected to a chlorine-containing gas atmosphere at a temperature of more than 400°C and the CdCl₂ and TeCl₂ forming during the etching process brought about in this way is caused to condense and deposit.

2. Method according to Claim 1, **characterized in that** a gas atmosphere containing chlorine and nitrogen is used in the method step.

3. Method according to Claim 1 or 2, **characterized in that** the hydrocarbon-based adhesives are ethylene/vinyl acetate copolymers (EVA).

4. Method according to one of the preceding claims, **characterized in that**, in an additional method step d) following step c), the TCO layer remaining on the glass is etched away with HCl gas, which is preferably diluted with nitrogen.

5. Method according to one of the preceding claims, **characterized in that** the pyrolysis and, if appropriate, the etching operation in step d) are carried out at temperatures above 400°C.

6. Method according to one of the preceding claims, **characterized in that** the gas atmosphere in method step c) and, if appropriate, d) is adjusted to a negative pressure.

7. Method according to one of Claims 2 to 6, **characterized in that** the gas atmosphere containing chlorine and nitrogen contains chlorine and nitrogen in a partial pressure ratio of chlorine to nitrogen between 0.01 and 0.1.

8. Method according to one of the preceding claims, **characterized in that** the pyrolysis is carried out in 1 to 15 minutes.

9. Method according to one of the preceding claims, **characterized in that** the etching in the gas atmosphere containing chlorine and possibly nitrogen is carried out at temperatures preferably above 450 °C.

10. Method according to one of the preceding claims, **characterized in that** the CdCl₂ forming during the etching operation and the TeCl₄ are obtained as a deposit on cold surfaces.

11. Method according to one of the preceding claims, **characterized in that** the CdCl₂ forming during the etching operation and the TeCl₄ are fed to refrigerated traps.

12. Method according to one of the preceding claims, **characterized in that** the CdCl₂ forming during the etching operation and the TeCl₄ are first brought to a temperature at which only the CdCl₂ forms a deposit, and are then cooled down further to a temperature at which the TeCl₄ is deposited.

13. Method according to one of the preceding claims, applied to glass substrates which are no longer covered with a rear glass and are already coated with CdTe/CdS.

## Revendications

1. Procédé de recyclage de modules de cellules solaires en couches minces en Cd/Te/CdS, dans lequel
a) on pulvérise les modules mécaniquement
b) on expose les fragments de modules à une atmosphère chargée d'oxygène, à une température d'au moins 300°C et on évacue les produits de décomposition gazeux, se formant par la pyrolyse ainsi provoquée des adhésifs sur base d'hydrocarbure et contenus dans les fragments, et
c) on expose les fragments de module libérés par les adhésifs à une atmosphère gazeuse à une température supérieure à 400°C et en ce que par refroidissement, on amène des CdCl₂ et des TeCl₄ ainsi formés par la corrosion provoquée de ce fait à la condensation et à la formation d'un sédiment.

2. Procédé selon la revendication 1, **caractérisé en ce qu'**on utilise une atmosphère gazeuse chlorée ou azotée au cours de l'étape du procédé.

3. Procédé selon la revendication 1 ou 2, **caractérisé en ce que** les adhésifs sont sur base de copolymères d'éthylène vinylacétate (EVA).

4. Procédé selon l'une quelconque des revendications précédentes, **caractérisé en ce qu'**au cours d'une étape de procédé supplémentaire d), consécutive à l'étape c), on décape à l'acide la couche de TCO restant sur le verre à l'aide de gaz HCL, de préférence dilué à l'azote.

5. Procédé selon l'une quelconque des revendications précédentes, **caractérisé en ce qu'**on réalise la pyrolyse et le cas échéant le processus de décapage sous l'étape d) à des températures supérieures à 400°C.

6. Procédé selon l'une quelconque des revendications précédentes, **caractérisé en ce que** sous l'étape c) et le cas échéant sous l'étape d), on règle l'atmosphère gazeuse sous dépression.

7. Procédé selon l'une quelconque des revendications 2 à 6, **caractérisé en ce que** l'atmosphère gazeuse chlorée et azotée contient du chlore et de l'azote en une proportion partielle de la pression de chlore et d'azote, entre 0,01 et 0,1.

8. Procédé selon l'une quelconque des revendications précédentes, **caractérisé en ce qu'**on réalise la pyrolyse entre de 1 à 15 minutes.

9. Procédé selon l'une quelconque des revendications précédentes, **caractérisé en ce qu'**on réalise le décapage sous atmosphère chlorée, le cas échéant azotée à des températures de 450°C de préférence;

10. Procédé selon l'une quelconque des revendications précédentes, **caractérisé en ce qu'**on récupère le CdCl₂ et le TeCl₄ se formant pendant le processus de décapage sous la forme de sédiments sur des surfaces froides.

11. Procédé selon l'une quelconque des revendications précédentes, **caractérisé en ce qu'**on amène le CdCl₂ et le TeCl₄ se formant pendant le processus de décapage à des pièges cryogéniques.

12. Procédé selon l'une quelconque des revendications précédentes, **caractérisé en ce qu'**on refroidit le CdCl₂ et le TeCl₄ se formant pendant le processus de décapage d'abord à une température à laquelle le CdCl₂ forme uniquement un sédiment, puis à une température à laquelle le TeCl₄ forme des sédiments.

13. Procédé selon l'une quelconque des revendications précédentes, appliqué sur des substrats vitreux d'ores et déjà recouverts de CdTe/CdS, mais pas encore d'un backglas.
